# EUROPEAN PATENT APPLICATION

(11) **EP 4 456 119 A1**
(43) Date of publication of application: **30.10.2024**
(21) Application number: 24167501.6
(22) Date of filing: 28.03.2024
(51) Int. Cl.: H01L 21/67, H01L 21/68

(54) **SUBSTRATE PROCESSING APPARATUS AND SUBSTRATE PROCESSING METHOD**

(30) Priority: 29.03.2023 KR 20230041434
(71) Applicant: PSK Inc., Hwaseong-si, Gyeonggi-do 18849 (KR)
(72) Inventor: JEONG, So Jin, 18449 Hwaseong-si (KR); KIM, Da In, 18449 Hwaseong-si (KR); PARK, Ju Young, 18449 Hwaseong-si (KR); NAM, Seong Min, 18449 Hwaseong-si (KR)
(74) Representative: HGF

(57) **Abstract**

Disclosed is a substrate processing apparatus and a substrate processing method that may reduce the time to obtain a center coordinate value when obtaining the center coordinate value of an edge region of a bevel-etched substrate. The substrate processing apparatus for inspecting a substrate in which a bevel-etched region is formed in an edge includes an inspection unit for setting at least three coordinates in an bevel-etched region of the substrate as inspection coordinates, and calculating center coordinates of a circle passing through the set at least three inspection coordinates as center coordinates of the bevel-etched region.

## Description

### TECHNICAL FIELD

The present invention relates to a substrate processing apparatus and a substrate processing method.

### BACKGROUND ART

Plasma refers to an ionized gas state formed of ions, radicals, electrons, and the like, and is generated by a very high temperature, strong electric fields, or RF electromagnetic fields. A semiconductor device manufacturing process includes an ashing or etching process of removing a membrane on a substrate by using plasma. The ashing or etching process is performed when ions and radical particles contained in the plasma collide or react with the membrane on the substrate. The process of processing the substrate by using the plasma is performed by various methods. Among them, the bevel etch device that processes the edge region of the substrate delivers plasma to the edge region of the substrate to bevel etch the edge region of the substrate, and the edge region of the bevel-etched substrate is formed in the form of a circular ring.

The substrate with the bevel-etched edge region is then inspected using a vision system to ensure that the edge region of the substrate is bevel etch with a uniform distance from an outer circumferential line of the substrate by inspecting whether a width between the outer circumferential line of the substrate and an inner line of the ring-shaped bevel-etched edge region is within a certain value.

In this case, the vision system sets 8 points in the inner area of the bevel-etched region, calculates the center value of each of the two points facing the center of the substrate, and calculates an average of the center values as the center coordinate of the bevel-etched region.

However, this method has the problem that the accuracy of the center coordinate value is degraded when the value of any one of the eight points is significantly out of the range when the eight points are selected, and it is time-consuming to find and input the values for the eight points individually.

### SUMMARY OF THE INVENTION

The present invention has been made in an effort to provide a substrate processing apparatus and a substrate processing method that may reduce the time to obtain a center coordinate value when obtaining the center coordinate value of an edge region of a bevel-etched substrate.

Further, the present invention has also been made in an effort to provide a substrate processing apparatus and a substrate processing method that improves the accuracy of a center coordinate value when obtaining the center coordinate value of an edge region of a bevel-etched substrate.

The object of the present invention is not limited thereto, and other objects not mentioned will be clearly understood by those of ordinary skill in the art from the following description.

According to an aspect, there is provided a substrate processing apparatus for inspecting a substrate in which a bevel-etched region is formed in an edge, the substrate processing apparatus including: an inspection unit for setting at least three coordinates in an bevel-etched region of the substrate as inspection coordinates, and calculating center coordinates of a circle passing through the set at least three inspection coordinates as center coordinates of the bevel-etched region.

The at least three inspection coordinates may be entered into an equation of a circle to calculate an unknown, and a center of the equation of the circle containing the unknown may be calculated as the center coordinates of the bevel-etched region.

The inspection unit may detect an inner line consisting of lines closest to the center of the substrate when viewing the bevel-etched region in a plane view of a wide surface of the substrate, and an outer circumferential line corresponding to an outer periphery of the substrate, and set the inspection coordinates on the inner line.

The inspection unit may set at least three coordinates in the bevel-etched region of the substrate as inspection coordinates to set the set inspection coordinates as a first group, and set at least three coordinates in the bevel-etched region of the substrate as inspection coordinates but sets at least three coordinates at positions different from the inspection coordinates set as the first group as inspection coordinates to set the set inspection coordinates as a second group, the inspection unit may calculate center coordinates of a circle passing through the inspection coordinates of the first group as first center coordinates of the bevel-etched region, and center coordinate of a circle passing through the inspection coordinates of the second group as second center coordinates of the bevel-etched region, and the inspection unit may calculate an average value of the first center coordinates and the second center coordinates as the center coordinates of the bevel-etched region.

The inspection unit may select the inspection coordinates of the first group and the inspection coordinates of the second group at positions arranged at a predetermined angle relative to the center of the substrate when selecting the inspection coordinates of the first group and the inspection coordinates of the second group.

The substrate processing apparatus may further include: a bevel etching unit for bevel etching an edge of the substrate to form the bevel-etched region, in which the bevel etching unit may include: a housing having a processing space; a support unit disposed in the processing space, utilized as a lower electrode, and supporting a substrate; an upper electrode unit disposed at a position opposite the support unit; a gas supply unit for supplying inert gas to a center region of the substrate and supplying process gas to an edge region of the substrate ; and a power source for supplying power to the upper electrode unit and the support unit to form plasma in an edge region of the substrate supplied with the process gas so that a bevel-etched region is formed on the substrate.

According to another aspect, there is provided a substrate processing method including: an etched region detection operation of detecting, by an inspection section, a bevel-etched region of a substrate; an inspection coordinate setting operation of detecting at least three inspection coordinates in the bevel-etched region; and a center coordinate calculation operation of setting, by the inspection unit, at least three coordinates in the bevel-etched region of the substrate as inspection coordinates, and calculating center coordinates of a circle passing through the set at least three inspection coordinates as center coordinates of the bevel-etched region.

The center coordinate calculation operation may include inputting the at least three inspection coordinates into an equation of a circle to calculate an unknown, and calculating a center of the equation of the circle containing the unknown as the center coordinates of the bevel-etched region.

The center coordinate calculation operation may include detecting, by the inspection unit, an inner line consisting of lines closest to a center of the substrate when viewing the bevel-etched region in a plane view of a wide surface of the substrate, and an outer circumferential line corresponding to an outer periphery of the substrate, and setting the inspection coordinates on the inner line.

The center coordinate calculation operation may include: setting, by the inspection unit, at least three coordinates in the bevel-etched region of the substrate as inspection coordinates to set the set inspection coordinates as a first group, and setting at least three coordinates in the bevel-etched region of the substrate as inspection coordinates but setting the at least three coordinates at positions different from the inspection coordinates set as the first group as inspection coordinates to set the set inspection coordinates as a second group; calculating, by the inspection unit, center coordinates of a circle passing through the inspection coordinates of the first group as first center coordinates of the bevel-etched region, and calculating center coordinates of a circle passing through the inspection coordinates of the second group as second center coordinates of the bevel-etched region; and calculating, by the inspection unit, an average value of the first center coordinates and the second center coordinates as the center coordinates of the bevel-etched region.

The center coordinate calculation operation may include selecting, by the inspection unit, the inspection coordinates of the first group and the inspection coordinates of the second group at positions arranged at a predetermined angle relative to the center of the substrate.

The substrate processing apparatus may include: an inspection unit for setting at least four coordinates of the substrate in the bevel-etched region as inspection coordinates, combining three inspection coordinates among the at least four inspection coordinates to generate a plurality of circles, and calculating an average value of center coordinates for each of the plurality of circles as center coordinates of the bevel-etched region.

The inspection unit may input three inspection coordinates passing through each of the plurality of circles into an equation of a circle to calculate an unknown when generating the plurality of circles, and calculate a center of the equation of the circle containing the unknown as the center coordinates of each of the plurality of circles.

The inspection unit may detect an inner line consisting of lines closest to the center of the substrate when viewing the bevel-etched region in a plane view of a wide surface of the substrate, and an outer circumferential line corresponding to an outer periphery of the substrate, and set the inspection coordinates on the inner line.

The inspection unit may select the four or more inspection coordinates at positions arranged at regular intervals at a predetermined angle with respect to the center of the substrate when the inspection unit selects the at least four inspection coordinates.

The substrate processing apparatus may further include a bevel etching unit for bevel etching an edge of the substrate to form the bevel-etched region, in which the bevel etching unit may include: a housing having a processing space; a support unit disposed in the processing space, utilized as a lower electrode, and supporting a substrate; an upper electrode unit disposed at a position opposite the support unit; a gas supply unit for supplying inert gas to a center region of the substrate and supplying process gas to an edge region of the substrate ; and a power source for supplying power to the upper electrode unit and the support unit to form plasma in the edge region of the substrate supplied with the process gas so that a bevel-etched region is formed on the substrate.

The substrate processing method may include: an inspection coordinate setting operation including detecting at least four inspection coordinates in the bevel-etched region; and a center coordinate calculation operation including setting, by the inspection unit, at least four coordinates of the substrate in the bevel-etched region as inspection coordinates, generating a plurality of circles by combining three inspection coordinates among the at least four inspection coordinates, and calculating an average value of the center coordinates for each of the plurality of circles as center coordinates of the bevel-etched region.

The center coordinate calculation operation may include detecting an inner line consisting of lines closest to the center of the substrate when viewing the bevel-etched region in a plane view of a wide surface of the substrate, and an outer circumferential line corresponding to an outer periphery of the substrate, and setting the inspection coordinates on the inner line.

The center coordinate calculation operation may include selecting, by the inspection unit, the at least four inspection coordinates at positions arranged at regular intervals at a predetermined angle with respect to the center of the substrate when the inspection unit selects the at least four inspection coordinates.

The center coordinate calculation operation may include inputting three inspection coordinates passing through each of the plurality of circles into an equation of a circle to calculate an unknown when generating the plurality of circles, and calculating a center of the equation of the circle containing the unknown as the center coordinates of each of the plurality of circles.

The present invention has the effect of reducing the time to obtain the center coordinate value when obtaining the center coordinate value of the edge region of the bevel-etched substrate.

Furthermore, the present invention has the effect of improving the accuracy of the center coordinate value when obtaining the center coordinate value of the edge region of the bevel-etched substrate.

The effect of the present invention is not limited to the foregoing effects, and nonmentioned effects will be clearly understood by those skilled in the art from the present specification and the accompanying drawings.

### BRIEF DESCRIPTION OF THE DRAWINGS

FIG. 1 is a plan view of a substrate processing apparatus of the present invention.
FIG. 2 is a cross-sectional view of a bevel etching unit provided in a process chamber of FIG. 1.
FIG. 3 is a partial side view of an inspection unit illustrated in FIG. 2.
FIG. 4 is a plan view of an example screen on which the inspection unit illustrated in FIG. 3 has detected a bevel-etched substrate.
FIG. 5 is a flowchart of a substrate processing method according to an example of the present invention.
FIG. 6 is a plan view of an example screen on which an inspection unit of a substrate processing apparatus detects a bevel-etched substrate according to another example of the present invention.
FIG. 7 is a flowchart of a substrate processing method according to another example of the present invention.
FIG. 8 is a plan view of an example screen in which an inspection unit of a substrate processing apparatus detects a bevel-etched substrate according to still another example of the present invention.
FIG. 9 is a flowchart of a substrate processing method according to another example of the present invention.

### DETAILED DESCRIPTION

Hereinafter, examples for carrying out the present invention will be described with reference to the accompanying drawings, and in this case, when it is the that a certain constituent element "includes" a certain constituent element throughout the specification, it is considered to mean that it may further include other constituent elements rather than controlling other constituent elements unless otherwise stated. In addition, terms such as "... unit" described in the specification is considered to mean a unit that processes at least one function or operation when describing electronic hardware or electronic software, and mean one component, a function, a use, a point, or a driving element when describing a mechanical device. In addition, hereinafter, the same or similar configurations will be described by using the same reference numerals, and overlapping descriptions of the same constituent elements will be omitted.

Further, when an element or layer is referred to in the present invention as being "on," "connected to," "coupled to," "attached to," "adjacent to," or "covering" another element or layer, it may be directly on, connected to, coupled to, attached to, adjacent to, or covering the other element or layer, or intermediate elements or layers may exist. Conversely, when an element is referred to as being "directly on," "directly connected to," or "directly bonded to" another element or layer, it is to be understood that no intervening elements or layers are present. Throughout the specification, the same reference numeral refers to the same element. As used in the present invention, the term "and/or" includes all combinations and sub-combinations of one or more of the enumerated items.

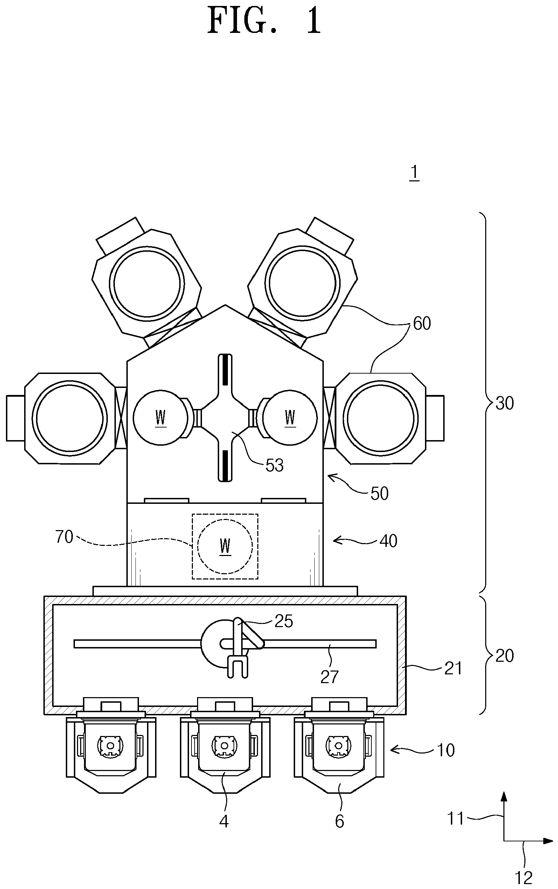

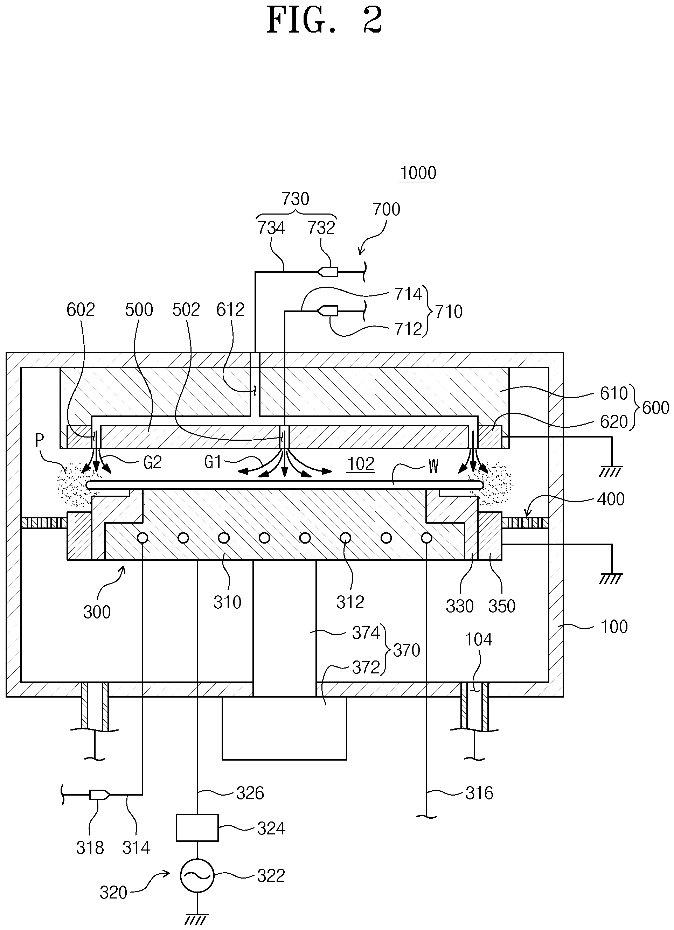

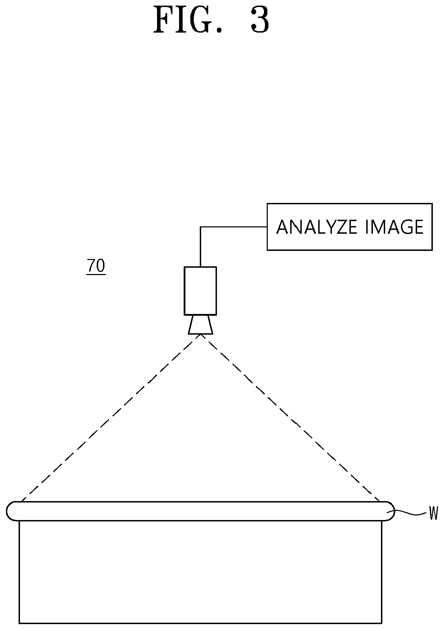

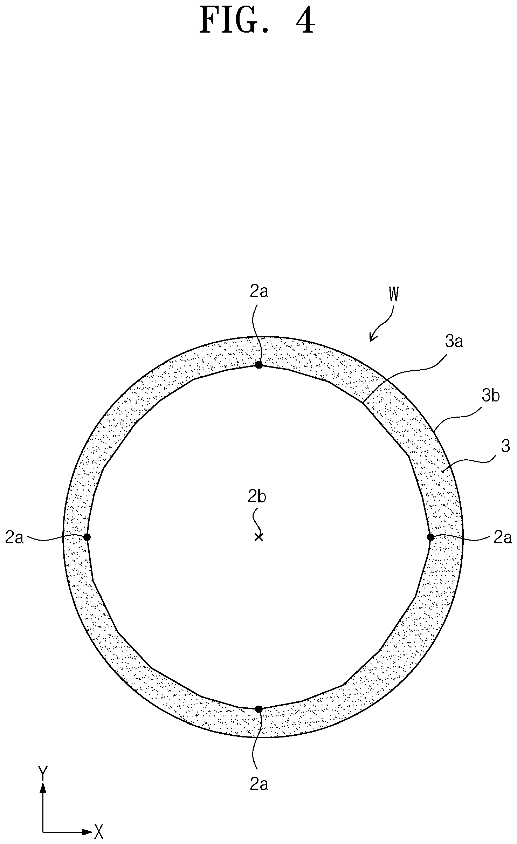

FIG. 1 is a plan view of a substrate processing apparatus of the present invention. FIG. 2 is a cross-sectional view of a bevel etching unit provided in a process chamber of FIG. 1. FIG. 3 is a partial side view of an inspection unit illustrated in FIG. 2. FIG. 4 is a plan view of an example screen on which the inspection unit illustrated in FIG. 3 has detected a bevel-etched substrate.

As shown in FIGS. 1 to 4, a substrate processing facility 1 includes an equipment front end module (EFEM) 20, a treating module30, a load lock chamber 40, a transfer chamber 50, a process chamber 60, and an inspection unit 70.

The EFEM 20 includes a load port 10 and a transfer frame 21. The load port 10 is disposed in front of the EFEM 20 in a first direction 11. The load port 10 includes a plurality of support parts 6. The support parts 6 are disposed in series in a second direction 12, and a carrier 4 (for example, a cassette, and an FOUP) in which a substrate W that is to be provided for a process and a processing completed substrate W is accommodated is seated on each support unit 6. In the carrier 4, the substrate W that is to be provided for a process and the process completed substrate W are accommodated. The transfer frame 21 is disposed between the load port 10 and the treating module 30. The transfer frame 21 includes a first transfer robot 25 which is disposed inside the transfer frame 21 and transfers the substrate W between the load port 10 and the treating module30. The first transfer robot 25 moves along a transfer rail 27 provided in the second direction 12 to transfer the substrate W between the carrier 4 and the treating module30.

The treating module30 includes a load lock chamber 40, a transfer chamber 50, and a process chamber 60. The treating module 30 may treat the substrate W by receiving the substrate W from the EFEM 20.

The load lock chamber 40 is disposed to be adjacent to the transfer frame 21. For example, the load lock chamber 40 may be disposed between the transfer chamber 50 and the EFEM 20. The load lock chamber 40 provides a place in which the substrate W to be provided for the process stands by before being transferred to the process chamber 60, or the processing completed substrate W stands by before being transferred to the EFEM 20.

The transfer chamber 50 may transfer the substrate W. The transfer chamber 50 is disposed to be adjacent to the load lock chamber 40. The transfer chamber 50 has a polygonal body when viewed from above. Referring to FIG. 1, the transfer chamber 50 has a pentagonal body when viewed from above. At the external side of the body, the load lock chamber 40 and the plurality of process chambers 60 are disposed along a circumference of the body. A passage (not illustrated) through which the substrate W enters and exists is formed on each sidewall of the body, and the passage connects the transfer chamber 50 and the load lock chamber 40 or the process chambers 60. Each passage is provided with a door (not illustrated) which opens/closes the passage to seal the interior. The second transfer robot 53 which transfers the substrate W between the load lock chamber 40 and the process chambers 60 is disposed in an internal space of the transfer chamber 50. The second transfer robot 53 transfers the untreated substrate W waiting in the load lock chamber 40 to the process chamber 60 or transfers the process completed substrate W to the load lock chamber 40. Then, the second transfer robot 53 transfers the substrate W between the process chambers 60 to sequentially provide the substrate W to the plurality of process chambers 60. As illustrated in FIG. 1, when the transfer chamber 50 has the pentagonal body, the load lock chamber 40 is disposed on the sidewall adjacent to the EFEM 20, and the process chambers 60 are consecutively disposed on the remaining sidewalls. The transfer chamber 50 may be provided in various forms depending on a demanded process module, as well as the foregoing shape.

The process chamber 60 may be disposed to be adjacent to the transfer chamber 50. The process chambers 60 are disposed along the circumference of the transfer chamber 50. The plurality of process chambers 60 may be provided. In each process chamber 60, the process processing may be performed on the substrate W. The process chamber 60 may receive the substrate W from the second transfer robot 53 and perform the process processing, and provides the second transfer robot 53 with the substrate W for which the process processing is completed. The process processing performed in the respective process chambers 60 may be different from each other.

The process chamber 60 also has a substrate apparatus device 1000 disposed in the processing space to bevel etch the edge regions of the substrate.

The substrate processing apparatus 1000 performs a predetermined process on the substrate W using plasma. For example, the substrate processing apparatus 1000 may etch or ash a film on the substrate W. The film may be various types of membrane, such as a poly silicon film, a silicon oxide film, a silicon nitride film. Further, the film may be a natural oxide film or a chemically produced oxide film. Further, the film may be a by-product generated in a process of processing the substrate W. Further, the film may be impurities attached and/or left on the substrate W.

In addition, the substrate processing apparatus 1000 may perform a plasma process on the substrate W. For example, the substrate processing apparatus 1000 may supply process gas and generate plasma from the supplied process gas to treat the substrate W. The substrate processing apparatus 1000 may supply process gas and generate plasma from the supplied process gas to treat an edge region of the substrate W.

As one example of the substrate processing apparatus 1000 for treating the edge region of the substrate W, the substrate processing apparatus 1000 may include a housing 100, a support unit 300, an exhaust plate 400, a dielectric plate 500, an upper electrode unit 600, and a gas supply unit 700.

The housing 100 may have a processing space 102 therein. An opening (not shown) may be formed in one surface of the housing 100. The substrate W may enter or exit from the processing space 102 of the housing 100 through the opening formed in the housing 100. The opening may be opened and closed by an opening member, such as a door (not shown). When the opening in the housing 100 is opened and closed by the opening/closing member, the processing space 102 of the housing 100 may be isolated from the outside. Additionally, the atmosphere in the processing space 102 of the housing 100 may be adjusted to a low pressure close to vacuum after being isolated from the outside. Additionally, an exhaust hole 104 may be formed in the bottom surface of the housing 100. Plasma P or gas G1 and G2 generated in the processing space 212 may be exhausted to the outside through the exhaust hole 104. Further, by-products generated in the process of processing the substrate W by using the plasma P may be discharged to the outside through the exhaust hole 104. Additionally, the exhaust hole 104 may be connected to an exhaust line (not shown). The exhaust line may be connected to a decompression member that provides decompression. The decompression member may provide decompression to the processing space 102 via an exhaust line.

The support unit 200 may support the substrate W in the processing space 102. The support unit 300 may include a chuck 310, a power member 320, an insulating ring 330, a lower electrode 350, and a drive member 370.

The chuck 310 may have a support surface supporting the substrate W. A heating means (not illustrated) may be provided inside the chuck 310. The heating means (not illustrated) may heat the chuck 310. The heating means may be a heater. Further, a cooling flow path 312 may be formed in the chuck 310. The cooling flow path 312 may be formed inside the chuck 310. A cooling fluid supply line 314 and a cooling fluid discharge line 316 may be connected to the cooling flow path 312. The cooling fluid supply line 314 may be connected with a cooling fluid supply source 318. The cooling fluid supply source 318 may store a cooling fluid and/or supply a cooling fluid to the cooling fluid supply line 314. Further, the cooling fluid supplied to a cooling flow path 312 may be discharged to the outside through the cooling fluid discharge line 316. The cooling fluid stored in and/or supplied by the cooling fluid supply source 318 may be cooling water or cooling gas. Further, the shape of the cooling flow path 312 formed in the chuck 310 is not limited to the shape shown and may be varied. Further, the configuration of cooling the chuck 310 is not limited to the configuration of supplying the cooling fluid, and may also be provided with various configurations (for example, a cooling plate) which are capable of cooling the chuck 310.

The power member 320 may provide power to the chuck 310. The power supply member 320 may include a power supply 322, a matcher 324, and a power supply line 326. The power supply 322 may be a bias power supply. The power supply 322 may be connected with the chuck 310 via the power supply line 326. Further, the matcher 324 is provided to the power supply line 326 to perform impedance matching. By the power supplied by the power source 322, the plasma generated in the processing space 102 may be moved in a direction toward the edge region of the substrate W.

The insulating ring 330 may have a shape that surrounds the chuck 310 when viewed from above. The insulating ring 330 may be provided between the chuck 310 and the lower electrode 350 described later. Since the chuck 310 is provided with a bias power source, the insulating ring 330 may be provided between the chuck 310 and the lower electrode 350 which is to be described below. The insulating ring 330 may be made of a material having an insulating property. Further, the insulating ring 330 may be formed with insertion grooves 332 into which the insertion rings 800 described later may be inserted. The insulating ring 330 will be described later.

The lower electrode 350 may be disposed below the edge region of the substrate W supported on the chuck 310. The lower electrode 350 may be provided to surround the insulating ring 330 when viewed from above. The lower electrode 350 may be disposed to face the upper electrode 620 which is to be described later. The lower electrode 350 may be disposed under the upper electrode 620 which is to be described below. The lower electrode 350 may be grounded. The lower electrode 350 may increase the plasma density by inducing coupling of the bias power applied to the chuck 310. Thus, the processing efficiency for the edge region of the substrate W may be improved.

The driving member 370 may lift the chuck 310. The driving member 370 may include a driver 372 and a shaft 374. The shaft 374 may be coupled with the chuck 310. The shaft 374 may be connected with the driver 372. The driver 372 may move up and down the chuck 310 in the vertical direction via the shaft 374.

The exhaust plate 400 may regulate airflow in the processing space 102. The exhaust plate 400 may be provided to surround the support unit 300 when viewed from above. The exhaust plate 400 may be provided between the housing 100 and the support unit 300 when viewed from above. The exhaust plate 400 may have a ring shape when viewed from above. The exhaust plate 400 may be formed with at least one or more holes through which the gases G1 and G2, by-products, and the plasma P in the processing space 102 may flow. Additionally, the exhaust plate 400 may be spaced apart from the housing 100 and any one of the lower electrodes 350.

The dielectric plate 500 may be disposed opposite the substrate W supported by the support unit 300 in the processing space 102. The dielectric plate 500 may be disposed above the support unit 300. The dielectric plate 500 may be made of a material including ceramic. The dielectric plate 500 may be formed with a first flow path 502 that is connected to an inert gas supply unit 710 of the gas supply unit 700 described later. Furthermore, the discharge end of the first flow path 502 may be configured such that the inert gas G1 is supplied to the center region of the substrate W supported on the support unit 300. Further, the discharge end of the first flow path 502 may be configured to supply the inert gas G1 to the top surface of the center region of the substrate W supported by the support unit 300.

The upper electrode unit 600 may include an upper body 610 and upper electrodes 620. The upper electrode 620 may be opposed to the lower electrode 350 described above. The upper electrode 620 may be disposed above the lower electrode 350. The upper electrode 620 may be disposed above the upper portion of the edge region of the substrate W supported on the chuck 310.

The upper electrode 620 may have a shape that surrounds the dielectric plate 500 when viewed from above. The upper electrode 620 may be coupled to the upper body 610 to be spaced apart from the dielectric plate 500. The upper electrode 620 may be grounded. The upper electrode 620 may be electrically coupled to the upper body 610. A gas channel 612 may be formed in the upper body 610. The gas channel 612 may be connected to a process gas supply unit 730 of the gas supply unit 700 described later. Further, the gas channel 612 may be in communication with a second flow path 602 formed by spacing the upper electrode 620 and the dielectric plate 500 apart from each other. Accordingly, process gas G2 supplied by process gas supply unit 730 may be supplied to the substrate W via the gas channel 612 and the second flow path 602. Further, the discharge end of the second flow path 602 may be configured such that the process gas G2 supplied by the process gas supply unit 730 is supplied to the edge region of the substrate W supported by the support unit 300.

The gas supply unit 700 may supply gas to the processing space 102. The gas supply unit 700 may supply inert gas G1 and process gas G2 to the processing space 102. The gas supply unit 700 may include an inert gas supply unit 710 and a process gas supply unit 730.

The inert gas supply unit 710 may supply inert gas G1 to the processing space 102. The inert gas supply unit 710 may include an inert gas supply source 712 and an inert gas supply line 714. The inert gas supply source 712 may store the inert gas G1 and/or supply the inert gas G1 to the inert gas supply line 714. The inert gas supply line 714 may be connected to the first flow path 502. Thus, the inert gas G1 supplied by the inert gas supply source 712 may be supplied to the center region of the top surface of the substrate W via the first flow path 502. The inert gas G1 may be gas including argon, nitrogen, or the like.

The process gas supply unit 730 may supply process gas G2 to the processing space 102. The process gas supply unit 730 may include a process gas supply source 732 and a process gas supply line 734. The process gas supply source 732 may store the process gas G2 and/or supply the process gas G2 to the process gas supply line 734. The process gas supply line 714 may be connected to the gas channel 612. The gas channel 612 is in communication with the second flow path 602 as described above. Thus, the process gas G2 supplied by the process gas supply source 732 may be supplied to the edge region of the top surface of the substrate W via the second flow path 602.

Describing the substrate processing apparatus 1000 performing a plasma process to bevel etch the edge of the substrate W, first, the inert gas G1 is supplied from the inert gas supply unit 710 to the center region of the top surface of the substrate W. Further, the process gas G2 is supplied to the edge region of the top surface edge of the substrate W from the process gas supply imot 730. Then, in the region between the upper electrode 620 and the lower electrode 350, power from the power source 322 is supplied, and plasma P is generated in the region where the process gas G2 is supplied. In this case, the generated plasma P may include ions and/or radicals. In this case, the inert gas is supplied to the center region of the substrate W, thereby preventing the process gas from penetrating into the center region of the substrate W. Thus, when the edge region of the substrate W is etched, the phenomenon of etching the center region of the substrate W is prevented. In other words, when the inert gas is supplied to the center region of the substrate W, the pressure in the center region of the substrate W becomes relatively higher than the pressure in the edge region of the substrate W, causing the inert gas to move from the center region of the substrate W to the edge region of the substrate W. Due to the gas flow, the process gas G2 is prevented from penetrating into the center region of the substrate W, and the plasma treatment efficiency for the edge region of the substrate W is further increased.

In this way, when the substrate processing device 1000 performs the plasma process, the edge region of the substrate is bevel etched to form a bevel-etched region 3.

The inspection unit 70 is disposed in the load lock chamber 40. In this case, the inspection unit 70 receives the bevel-etched substrate W from the second transfer robot 53 that transfers the substrate W and inspects the substrate W. Here, the disposition position of the inspection unit 70 is illustrated as being disposed within the load lock chamber 40 so that the inspection is performed immediately after bevel etching, but the inspection unit 70 may also be disposed in the transfer chamber 50 to inspect the substrate W, and may also be disposed on the outer side of the transfer frame 21 to inspect the substrate W transferred to the outer side of the load port 10. In other words, the present invention is not limited to the above examples of the disposition of the inspection unit 70, and it is of course possible to implement various variations.

As one example of the inspection unit 70, the inspection unit 70 may utilize a vision inspection device that acquires image information by photographing the substrate W with a camera, and acquires the bevel-etched region 3 by image processing the acquired image information. In addition, as another example of the inspection unit 70, the inspection unit 70 may acquire region information about the bevel-etched region 3 as coordinate data by using a position detection sensor, a laser sensor, an infrared sensor, and the like capable of detecting the bevel-etched region 3, other than the method using the vision inspection apparatus, and analyze the acquired data. In other words, the way in which the inspection unit 70 analyzes the bevel-etched region 3 of the substrate W in the present invention is not limited to the above examples, and it will be readily apparent to those skilled in the art that various variations of the method of acquiring and making the obtained position information of the bevel-etched region 3 into data may be utilized.

For ease of understanding, the present example will be described based on the case where the inspection unit 70 uses the vision inspection device when inspecting the substrate W.

Accordingly, the inspection unit 70 acquires image information of the substrate W, and image-processes the acquired image information, and distinguishes and detects the bevel-etched region 3 having a contrast or color form different from that near the center of the substrate. In this case, the inspection unit 70 detects the bevel-etched region 3 as an inner line 3a consisting of the lines closest to the center of the substrate when viewing the bevel-etched region 3 in a plane view of a wide surface of the substrate, and an outer circumferential line 3b corresponding to the outer periphery of the substrate. Here, the inner line 3a may consist of a circle when the substrate W is ideally bevel etched, but may be an ellipse or a partially jagged curve in the form of a closed loop, depending on the substrate W. At this time, the inspection unit 70 sets at least three or more coordinates on the inner line 3a of the bevel-etched region 3 of the substrate W as inspection coordinates 2a, and calculates the center coordinates of the circle passing through the set at least three or more inspection coordinates 2a as center coordinate 2b of the inner line 3a of the bevel-etched region 3, so that the center coordinates of the bevel-etched region 3 may be easily calculated.

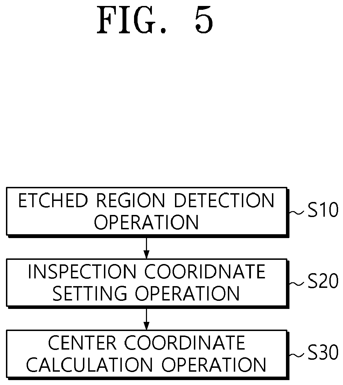

FIG. 5 is a flowchart of a substrate processing method according to an example of the present invention.

Referring further to FIG. 5 to describe an example of a substrate processing method of calculating the center coordinates of the bevel-etched region 3, the substrate processing method may include an etching region detection operation S10, an inspection coordinate setting operation S20, and a center coordinate calculation operation S30.

First, in the etching area detection operation S10, as described above, the inspection unit 70 acquires image information of the substrate W, and image-processes the acquired image information to distinguish and detect the bevel-etched region 3, which has a contrast or color form different from that near the center of the substrate.

Next, in the inspection coordinate setting operation S20, the inspection unit 70 sets at least three inspection coordinates 2a on the inner line 3a of the bevel-etched area, and in this case, the at least three inspection coordinates 2a may be selected at positions arranged at regular intervals at a predetermined angle with respect to the center of the substrate W. For example, when the inspection unit 70 sets four inspection coordinates 2a, the four inspection coordinates 2a may be selected with the inspection coordinates 2a at points on the inner line 3a corresponding to 90 degrees, 180 degrees, and 270 degrees, respectively, when the +X axis is oriented 0 degrees from the center of the substrate in a plane with the X and Y axes. In this case, the inspection coordinates 2a may be set by entering the coordinates to be specified manually by the user, or may be set automatically by a preset program. In this case, the inspection coordinates 2a may be set to three to minimize the inspection time or to four to minimize the inspection time and increase the accuracy, since the problem of increasing the calculation time may occur when eight or more coordinates are selected as in the existing method. Furthermore, the inspection coordinates 2a are preferably set at a specified angle as exemplified in the present example, since inspection accuracy may be non-uniform for each substrate W when the angle is not specified, as exemplified in the present example.

Next, in the center coordinate calculation operation S30, as illustrated, when the four inspection coordinates 2a are set, the inspection unit 70 inputs each of the four inspection coordinates 2a into the general form of the equation of a circle. In this case, the general form of the equation of a circle may be expressed as X2+Y2+AX+BY+C (where A, B, and C are unknowns) in the plane bounded by the x-axis and the y-axis. In this case, the unknown may be obtained by using three inspection coordinates 2a, but is illustrated as consisting of four that is more than three to improve the accuracy of the inspection. AS described above, the inspection unit 70 obtaining the unknown by using the four inspection coordinates 2a calculates the center of the circle by using the equation of the circle as the center coordinates 2b of the bevel-etched region 3. In this way, the inspection unit 70 may very easily calculate the center coordinates of the bevel etch area 3.

In the following, example that are different from the above example will be described.

In the following examples, substrate processing and bevel etching are performed by using the substrate processing facility 1 and the substrate processing apparatus 1000 described above, and redundant configurations will be omitted so as not to obscure the essence of the description, and only the focused contents will be described.

Accordingly, in order to adopt a more accurate method for obtaining the center coordinates of the bevel-etched region 3 formed on the substrate W as described above, the following analysis method of the inspection unit 70 according to another example may be configured.

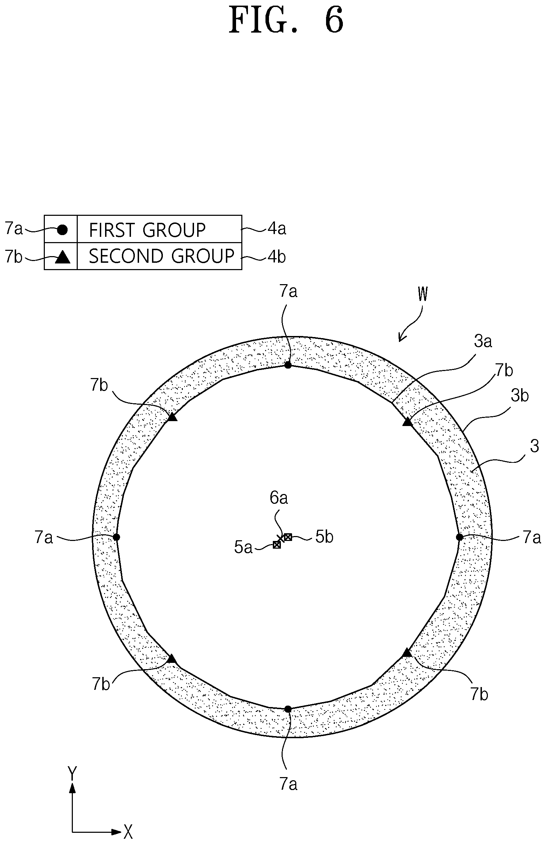

Referring further to FIG. 6, FIG. 6 is a plan view of an example screen on which the inspection unit 70 of the substrate processing apparatus detects the bevel-etched substrate W according to another example of the present invention.

In the present example, the inspection unit 70 acquires image information of the substrate W by using a vision inspection device as in the previous example, and the difference from the previous example is that the analysis method of the inspection unit 70 is different from the previous example.

More specifically, in the substrate processing apparatus according to another example of the present invention, the inspection unit 70, which acquires the image information of the substrate in which the bevel-etched region 3 is formed, detects the inner line 3a consisting of the lines closest to the center of the substrate and the outer circumferential line 3b corresponding to the outer periphery of the substrate when the bevel-etched region 3 is viewed in a plane view of a wide surface of the substrate. Next, the inspection unit 70 sets at least three coordinates on the inner line 3a of the bevel-etched region 3 of the substrate as inspection coordinates 7a, which are set to a first group 4a. Next, the inspection unit 70 sets at least three coordinates on the inner line 3a of the bevel-etched region 3 of the substrate as inspection coordinates 7b, but sets the inspection coordinates 7b at a position different from the inspection coordinates 7a set in the first group 4a and set the inspection coordinates 7b as the second group 4b. In this case, the inspection unit 70 calculates the center coordinates of the circle passing through the inspection coordinates 7a of the first group 4a as first center coordinates 5a of the bevel-etched region 3, and the center coordinates of the circle passing through the inspection coordinates 7b of the second group 4b as second center coordinates 5b of the bevel-etched region 3. Next, the inspection unit 70 calculates the average value of the first center coordinates 5a and the second center coordinates 5a as center coordinates 6a of the bevel-etched region 3, which makes it possible to calculate center coordinates 6a of the bevel-etched region 3 with great ease, and makes it possible to calculate the center coordinates 6a of the bevel-etched region 3 with higher accuracy than in the previous example.

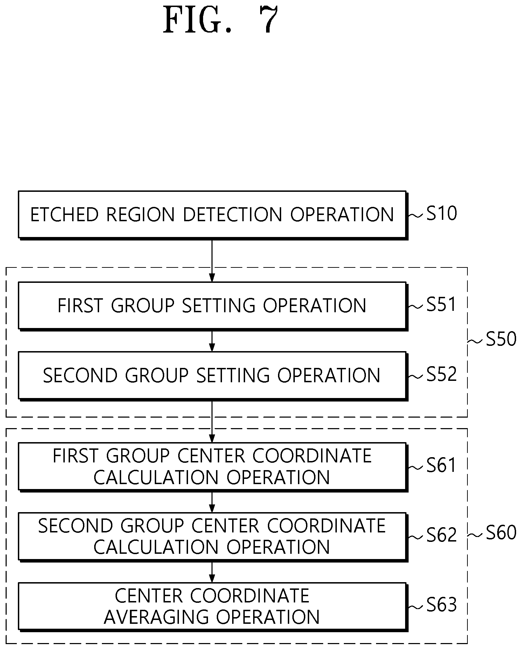

Continuing to describe the substrate processing method of the substrate processing apparatus according to the another example described above, FIG. 7 is a flowchart of a substrate processing method according to another example of the present invention.

Referring further to FIG. 7, the substrate processing method according to another example of the present invention includes an etching region detection operation S10, an inspection coordinate setting operation S50, and a center coordinate calculation operation S60.

First, the etched region detection operation S10 is performed the same as in the previous example, and a redundant description of the same will be omitted.

Next, the inspection coordinate setting operation S50 includes a first group setting operation S51 and a second group setting operation S52.

First, in the first group setting operation S51, the inspection unit 70 sets the coordinates of at least three of the eight points of the inner line 3a of the bevel-etched region of the substrate as inspection coordinates 7a to set the inspection coordinates 7a as a first group 4a. In the present example, four inspection coordinates 7a are set in the first group setting operation S51. In this case, the four inspection coordinates 7a may be set with a preset angle between the inspection coordinates 2a, such as being arranged to form a 90-degree angle between each other, in order to ensure that the inspection proceeds at the same location for each substrate W to be inspected as described above.

Next, in the second group setting operation S52, the inspection unit 70 sets another four inspection coordinates 7b among the eight points on the inner line 3a of the bevel-etched region 3 so that the four inspection coordinates 7a selected in the first group 4a do not overlap. In this case, the other four inspection coordinates 7b are at a preset angle to each other as described above.

Next, the center coordinate calculation operation S60 includes a first group center coordinate calculation operation S61, a second group center coordinate calculation operation S62, and a center coordinate averaging operation S63.

First, in the first group center coordinate calculation operation S61, the inspection unit 70 calculates the center coordinates of a circle passing through the inspection coordinates 7a set in the first group 4a as first center coordinates 5a of the bevel-etched region 3. Here, the center coordinates of the circle may be calculated by obtaining an unknown for the equation of the circle, as exemplified in the preceding example.

Next, in the second group center coordinate calculation operation S62, the inspection unit 70 calculates the center coordinates of the circle passing through the inspection coordinates 7b of the second group 4b as second center coordinates 5b of the bevel-etched region 3. The center coordinates of the circle may also be calculated by obtaining the unknowns in the equation of the circle described above.

Next, in the center coordinate averaging operation S63, the inspection unit 70 calculates the average value of the first center coordinates 5a and the second center coordinates 5b as center coordinates 6a of the bevel-etched region 3. Here, the average value of the center coordinates of the bevel-etched region 3 is calculated with the average value of the X-axis value of the first center coordinates 5a and the X-axis value of the second center coordinates 5b on a plane based on the X-axis and the Y-axis, and the average value of the Y-axis value of the first center coordinates 5a and the Y-axis value of the second center coordinates 5b.

Thus, the center coordinates 6a for the inner line 3a of the bevel-etched region 3 is calculated very easily, and it is possible to calculate the center coordinates of the bevel-etched region 3 with higher accuracy than in the previous example.

On the other hand, in order to calculate the center coordinates for the inner line 3a of the bevel-etched region 3 with higher accuracy than the aforementioned examples, another example of the present invention may be proceeded with as follows.

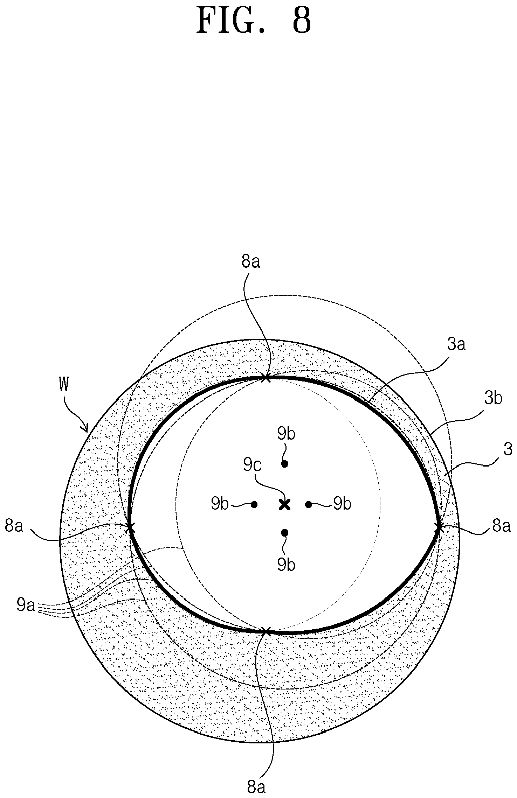

Referring now to FIG. 8, FIG. 8 is a plan view of an example screen in which an inspection unit of a substrate processing apparatus detects a bevel-etched substrate according to still another example of the present invention. In FIG. 8, the bevel-etched region 3 formed on the substrate W is shown in a somewhat exaggerated form to facilitate understanding of the present example.

In the substrate processing apparatus according to another example of the present invention, the inspection unit 70 sets at least four coordinates in the bevel-etched region 3 as inspection coordinates 8a, combines three inspection coordinates 8a out of the four or more inspection coordinates 8a to generate a plurality of circles 9a, and calculates an average value of center coordinates 9b for each of the plurality of circles 9a as center coordinates 9c of the bevel-etched region 3.

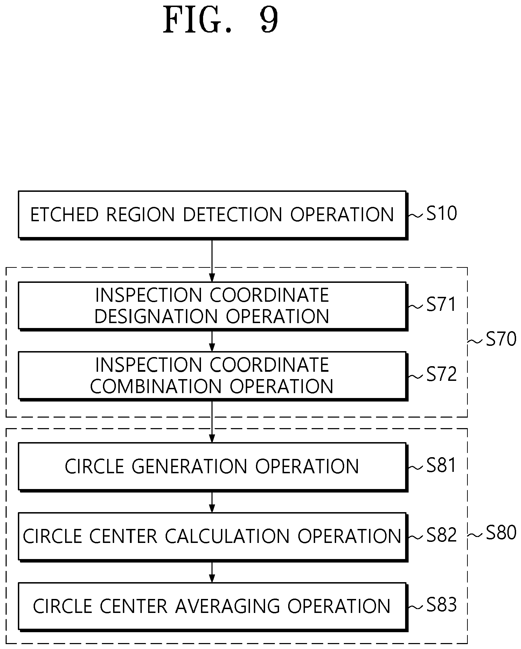

In order to describe this in more detail, a substrate processing method according to another example of the present invention will be described with further reference to FIG. 9.

FIG. 9 is a flowchart of a substrate processing method according to another example of the present invention.

Referring further to FIG. 9, a substrate processing method according to another example of the present invention includes an etch area detection operation S10, an inspection coordinate setting operation S70, and a center coordinate calculation operation S80.

First, the etching area detection operation S10 is the same as the previous example, so a redundant description will be omitted.

Next, the inspection coordinate setting operation S70 includes an inspection coordinate designation operation S71 and an inspection coordinate combination operation S72.

First, in the inspection coordinate setting operation S71, the inspection unit 70 sets at least four coordinates on the inner line 3a of the bevel-etched region 3 as inspection coordinates 8a. In the present example, in the inspection coordinate designation operation S71, it is exemplified that the four inspection coordinates 8a are arranged and set at a preset angle, similar to the above-described method of setting the inspection coordinates.

Next, in the inspection coordinate combination operation S72, the inspection unit 70 combines three inspection coordinates 8a among the four inspection coordinates 8a set in the previous operation.

Next, the center coordinate calculation operation S80 includes a circle generation operation S81, a circle center calculation operation S82, and a center coordinate averaging operation S83.

First, in the circle generation operation S81, the inspection unit 70 generates circles 9a for each of the four combinations generated in the inspection coordinate combination operation S72. Here, the circle generation method may be set to obtain the unknowns in the equation of the circle passing through the three points as described above. Here, in the circle generation operation S81, the number of combinations corresponds to a total of four as described above. Then, since the number of combinations generated by selecting three inspection coordinates 8a of the four inspection coordinates 8a is 4C3, the plurality of circles 9a is made up of a total of four circles. Of course, the number of combinations of the plurality of circles 9a may change as the number of inspection coordinates 8a increases, and in the present example, it will be exemplified as the plurality of circles 9a is four for ease of understanding.

Next, in the circle center calculation operation S82, the inspection unit 70 calculates the respective center coordinates 9b from the equation of the circle for each of the four circles 9a generated by the aforementioned operations. Here, the equation of the circle may be calculated by the method of obtaining the unknowns as described above.

Next, in the center coordinate averaging operation S83, the inspection unit 70 averages the center coordinates 9b of each of the four circles 9a to calculate center coordinates 9c for the inner line 3a of the bevel etch area 3. Here, the average value of the center coordinates 9b of each of the four circles 9a is calculated by calculating the average value of the x-axis of the center coordinates 9b for each of the four circles in a plane with respect to the x-axis and the y-axis, and by calculating the average value of the y-axis of the center coordinates 9b for each of the four circles, and the average value of the x-axis and the average value of the y-axis are set as the center coordinates 9c for the inner line 3a.

Thus, the center coordinates 9c for the inner line 3a of the bevel-etched region 3 may be calculated very easily by setting only four points, and the center coordinates 9c of the bevel-etched region 3 may be calculated with higher accuracy than in the previous example.

As described above, the present invention has been described with reference to the specific matters, such as a specific component, limited examples, and drawings, but these are provided only for helping general understanding of the present invention, and the present invention is not limited to the aforementioned examples, and those skilled in the art will appreciate that various changes and modifications are possible from the description.

## Claims

1. A substrate processing apparatus (1) for inspecting a substrate (W) in which a bevel-etched region (3) is formed in an edge, the substrate processing apparatus (1) comprising:
an inspection unit (70) for setting at least three coordinates in an bevel-etched region of the substrate as inspection coordinates (2a, 7a, 8a), and calculating center coordinates of a circle passing through the set at least three inspection coordinates as center coordinates (2b) of the bevel-etched region.

2. The substrate processing apparatus of claim 1, wherein the at least three inspection coordinates (2a, 7a) are entered into an equation of a circle to calculate an unknown, and a center of the equation of the circle containing the unknown is calculated as the center coordinates (2b) of the bevel-etched region (3).

3. The substrate processing apparatus of claim 1 or claim 2, wherein the inspection unit (70) sets at least three coordinates in the bevel-etched region (3) of the substrate (W) as inspection coordinates (2a, 7a) to set the set inspection coordinates as a first group (4a), and sets at least three coordinates in the bevel-etched region (3) of the substrate (W) as inspection coordinates (2a, 7a) but sets at least three coordinates at positions different from the inspection coordinates (2a, 7a) set as the first group (4a) as inspection coordinates (2a, 7a) to set the set inspection coordinates (2a, 7a) as a second group (4b),
the inspection unit (70) calculates center coordinates of a circle passing through the inspection coordinates (2a, 7a) of the first group (4a) as first center coordinates (5a) of the bevel-etched region (3), and center coordinate of a circle passing through the inspection coordinates (2a, 7a) of the second group (4b) as second center coordinates (5b) of the bevel-etched region (3), and
the inspection unit (70) calculates an average value of the first center coordinates (5a) and the second center coordinates (5b) as the center coordinates of the bevel-etched region (3), and optionally
wherein the inspection unit (70) selects the inspection coordinates (2a, 7a) of the first group (4a) and the inspection coordinates (2a, 7a) of the second group (5b) at positions arranged at a predetermined angle relative to the center of the substrate (W) when selecting the inspection coordinates (2a, 7a) of the first group (5a) and the inspection coordinates (2a, 7a) of the second group (5b).

4. The substrate processing apparatus of claim 1, wherein the inspection unit (70) for setting at least four coordinates of the substrate (W) in the bevel-etched region (3) as inspection coordinates (8a), combining three inspection coordinates (8a) among the at least four inspection coordinates (8a) to generate a plurality of circles (9a), and calculating an average value of center coordinates for each of the plurality of circles (9a) as center coordinates of the bevel-etched region (3).

5. The substrate processing apparatus of claim 4, wherein the inspection unit (70) inputs three inspection coordinates (8a) passing through each of the plurality of circles (9a) into an equation of a circle to calculate an unknown when generating the plurality of circles (9a), and calculates a center of the equation of the circle containing the unknown as the center coordinates of each of the plurality of circles (9a).

6. The substrate processing apparatus of claim 4 or claim 5, wherein the inspection unit (70) selects the four or more inspection coordinates (8a) at positions arranged at regular intervals at a predetermined angle with respect to the center of the substrate (W) when the inspection unit (70) selects the at least four inspection coordinates (8a).

7. The substrate processing apparatus of any preceding claim, wherein the inspection unit (70) detects an inner line (3a) consisting of lines closest to the center of the substrate (W) when viewing the bevel-etched region (3) in a plane view of a wide surface of the substrate (W), and an outer circumferential line (3b) corresponding to an outer periphery of the substrate, and sets the inspection coordinates (2a, 7a) on the inner line (3a).

8. The substrate processing apparatus of any preceding claim, further comprising:
a bevel etching unit for bevel etching an edge of the substrate (W) to form the bevel-etched region,
wherein the bevel etching unit includes:
a housing (100) having a processing space (102);
a support unit (300) disposed in the processing space (102), utilized as a lower electrode (350), and supporting a substrate (W);
an upper electrode unit (600) disposed at a position opposite the support unit (300);
a gas supply unit (700) for supplying inert gas to a center region of the substrate (W) and supplying process gas to an edge region of the substrate (W) ; and
a power source (322) for supplying power to the upper electrode unit (600) and the support unit (300) to form plasma in an edge region of the substrate (W) supplied with the process gas so that a bevel-etched region (3) is formed on the substrate (W).

9. A substrate processing method comprising:
an etched region detection operation (S10) of detecting, by an inspection section, a bevel-etched region (3) of a substrate (W);
an inspection coordinate setting operation (S20) of detecting at least three inspection coordinates (2a, 7a, 8a) in the bevel-etched region (3); and
a center coordinate calculation operation (S30, S80) of setting, by the inspection unit (70), at least three coordinates in the bevel-etched region (3) of the substrate (W) as inspection coordinates (2a, 7a), and calculating center coordinates of a circle passing through the set at least three inspection coordinates (2a, 7a) as center coordinates of the bevel-etched region (3).

10. The substrate processing method of claim 9, wherein the center coordinate calculation operation (S30) includes inputting the at least three inspection coordinates (2a, 7a) into an equation of a circle to calculate an unknown, and calculating a center of the equation of the circle containing the unknown as the center coordinates of the bevel-etched region (3).

11. The substrate processing method of claim 9 or claim 10, wherein the center coordinate calculation operation (S30) includes:
setting, by the inspection unit (70), at least three coordinates in the bevel-etched region (3) of the substrate (W) as inspection coordinates to set the set inspection coordinates (2a, 7a) as a first group (4a), and setting at least three coordinates in the bevel-etched region (3) of the substrate (W) as inspection coordinates (2a, 7a) but setting the at least three coordinates at positions different from the inspection coordinates (2a, 7a) set as the first group (4a) as inspection coordinates (2a, 7a) to set the set inspection coordinates as a second group (4b);
calculating, by the inspection unit (70), center coordinates of a circle passing through the inspection coordinates (2a, 7a) of the first group (4a) as first center coordinates (5a) of the bevel-etched region (3), and calculating center coordinates of a circle passing through the inspection coordinates (2a, 7a) of the second group (4b) as second center coordinates (5b) of the bevel-etched region (3); and
calculating, by the inspection unit (70), an average value of the first center coordinates (5a) and the second center coordinates (5b) as the center coordinates of the bevel-etched region (3), and optionally
wherein the center coordinate calculation operation (S30) includes selecting, by the inspection unit (70), the inspection coordinates of the first group (4a) and the inspection coordinates (2a, 7a) of the second group (4b) at positions arranged at a predetermined angle relative to the center of the substrate (W).

12. The substrate processing method of claim 9,
wherein the inspection coordinate setting operation (S70) includes detecting at least four inspection coordinates (8a) in the bevel-etched region (3); and
wherein the center coordinate calculation operation (S80) includes setting, by the inspection unit (70), at least four coordinates of the substrate (W) in the bevel-etched region (3) as inspection coordinates (8a), generating a plurality of circles (9a) by combining three inspection coordinates (8a) among the at least four inspection coordinates (8a), and calculating an average value of the center coordinates for each of the plurality of circles (9a) as center coordinates of the bevel-etched region (3).

13. The substrate processing method of claim 12, wherein the center coordinate calculation operation (S80) includes selecting, by the inspection unit (70), the at least four inspection coordinates (8a) at positions arranged at regular intervals at a predetermined angle with respect to the center of the substrate (W) when the inspection unit (70) selects the at least four inspection coordinates (8a).

14. The substrate processing method of claim 12 or claim 13, wherein the center coordinate calculation operation (S80) includes inputting three inspection coordinates (8a) passing through each of the plurality of circles (9a) into an equation of a circle to calculate an unknown when generating the plurality of circles (9a), and calculating a center of the equation of the circle containing the unknown as the center coordinates of each of the plurality of circles (9a).

15. The substrate processing method of any one of claims 9 to 14, wherein the center coordinate calculation operation (S30) includes detecting, by the inspection unit (70), an inner line (3a) consisting of lines closest to a center of the substrate (W) when viewing the bevel-etched region (3) in a plane view of a wide surface of the substrate (W), and an outer circumferential line (3b) corresponding to an outer periphery of the substrate (W), and setting the inspection coordinates (2a, 7a) on the inner line (3a).
